# EUROPEAN PATENT APPLICATION

(11) **EP 4 549 981 A1**
(43) Date of publication of application: **07.05.2025**
(21) Application number: 24211220.9
(22) Date of filing: 06.11.2024
(51) Int. Cl.: G01R 33/38, G01R 33/54, G01R 33/3815

(54) **OPERATION TERMINAL, METHOD FOR OPERATING OPERATION TERMINAL, AND MAGNETIC RESONANCE IMAGING SYSTEM**

(30) Priority: 06.11.2023 JP 2023189577
(71) Applicant: FUJIFILM Corporation, Tokyo 106-8620 (JP)
(72) Inventor: HORIO, Hideyuki, Tokyo, 106-8620 (JP); YATSUO, Takeshi, Tokyo, 106-8620 (JP); FUJIKAWA, Takuya, Tokyo, 106-8620 (JP); NAKASHIMA, Yutaro, Tokyo, 106-8620 (JP); NAGAO, Hisako, Tokyo, 106-8620 (JP)
(74) Representative: Dehns Germany Partnerschaft mbB

(57) **Abstract**

An object of the present invention is to provide an operation terminal, a method for operation an operation terminal, and a magnetic resonance imaging system including the operation terminal that enable a user to correctly understand a state of a magnet. An operation terminal according to an aspect of the present invention is an operation terminal for a magnetic resonance imaging apparatus and includes a processor configured to: acquire information indicating a temperature of a magnet provided in the magnetic resonance imaging apparatus from the magnetic resonance imaging apparatus; calculate a remaining cooling time, which is a time required until the magnet is cooled to a cooling-completed state, on the basis of the acquired information; and output information indicating the calculated remaining cooling time.

## Description

### BACKGROUND OF THE INVENTION

### 1. Field of the Invention

The present invention relates to an operation terminal for a magnetic resonance imaging apparatus, a method for operating an operation terminal, and a magnetic resonance imaging system, and particularly to a technique that notifies of a cooling state of a magnet provided in the magnetic resonance imaging apparatus.

### 2. Description of the Related Art

In a magnetic resonance imaging (MRI) apparatus (MRI apparatus), a superconducting magnet has been cooled using liquid helium. In this MRI apparatus, since the control or adjustment of the cooling of the superconducting magnet requires advanced knowledge or techniques, specialized service personnel have performed the work.

On the other hand, in recent years, a technique of reducing the amount of liquid helium used and a technique of cooling a magnet without using liquid helium have been developed. It is expected that these techniques will be further improved in the future. For example, JP2013-144099A discloses an MRI apparatus in which a cooling container is a liquid helium-free cooling container.

### SUMMARY OF THE INVENTION

In view of the progress of the technique of reducing the amount of liquid helium used and the technique of cooling the magnet without using liquid helium, it is preferable that not only the specialized service personnel with advanced knowledge and techniques but also a general user, such as an engineer using the MRI apparatus in a normal examination or the like, can correctly understand the state of the magnet and perform an appropriate operation. However, the technique according to the related art disclosed in JP2013-144099A does not enable the general user to correctly understand the state of the magnet.

The present invention has been made in view of the above circumstances, and an object of the present invention is to provide an operation terminal, a method for operating an operation terminal, and a magnetic resonance imaging system including the operation terminal that enable a user to correctly understand a state of a magnet.

In order to achieve the above-described object, an operation terminal according to a first aspect of the present invention is an operation terminal for a magnetic resonance imaging apparatus and comprises a processor configured to: acquire information indicating a temperature of a magnet provided in the magnetic resonance imaging apparatus from the magnetic resonance imaging apparatus; calculate a remaining cooling time, which is a time required until the magnet is cooled to a cooling-completed state, on the basis of the acquired information; and output information indicating the calculated remaining cooling time.

According to the first aspect, the remaining cooling time of the magnet (time required until the magnet is cooled to the cooling-completed state) is output. Therefore, the user can correctly understand the state of the magnet.

According to a second aspect, in the operation terminal according to the first aspect, the operation terminal may further comprise a non-transitory tangible recording medium in which data of a cooling curve, which indicates a relationship between a time from a start of the cooling of the magnet and the temperature of the magnet and which has been generated on the basis of an actually measured value, is recorded. The processor may be configured to calculate the time with reference to the recorded data of the cooling curve. The second aspect defines a specific aspect of the calculation of the remaining cooling time.

According to a third aspect, in the operation terminal according to the second aspect, as the data of the cooling curve, data of a plurality of cooling curves corresponding to a type of a cooling device that cools the magnet and a change in the cooling device over time may be recorded in the recording medium, and the processor may be configured to interpolate the data of the plurality of cooling curves according to the type of the cooling device and the change in the cooling device over time to calculate the remaining cooling time. The remaining cooling time can be accurately calculated by interpolating the data of the plurality of cooling curves as in the third aspect.

According to a fourth aspect, in the operation terminal according to the second or third aspect, the processor may be configured to newly generate data of a cooling curve indicating a relationship between a cooling time of the magnet and the temperature of the magnet on the basis of an actually measured value of the temperature of the magnet and to record the generated data of the cooling curve in the recording medium. The change in the cooling curve depends on the characteristics of each cooling device, the installation conditions of the magnetic resonance imaging system, or the like. However, the remaining cooling time can be accurately calculated by the generation and record of the data of the cooling curve based on the actually measured value as in the fourth aspect. In addition, a method used to generate the new data is not particularly limited. For example, a machine learning method can be used.

According to a fifth aspect, in the operation terminal according to any one of the second to fourth aspects, the processor may display the data of the cooling curve on a display device. According to the fifth aspect, a user of the operation terminal can easily visually ascertain the cooling curve.

According to a sixth aspect, in the operation terminal according to any one of the first to fifth aspects, the cooling-completed state may be a state in which a superconducting state of the magnet is maintained and it is possible to start exciting the magnet.

According to a seventh aspect, in the operation terminal according to any one of the first to sixth aspects, the processor may be configured to output the information using at least one of display output or voice output.

According to an eighth aspect, in the operation terminal according to any one of the first to seventh aspects, the processor may be configured to discretely output the information according to the remaining cooling time.

According to a ninth aspect, in the operation terminal according to any one of the first to eighth aspects, the processor may be configured to determine a small granularity for the information stepwise according to the remaining cooling time and to output the information with the determined granularity. In the ninth aspect, the "granularity" is an output unit of information and can be smaller as the remaining cooling time is shorter.

In order to achieve the above-mentioned object, a method for operating an operation terminal according to a tenth aspect of the present invention is a method for operating an operation terminal for a magnetic resonance imaging device. The operation terminal includes a processor. The method comprises causing the processor to: acquire information indicating a temperature of a magnet provided in the magnetic resonance imaging apparatus from the magnetic resonance imaging apparatus; calculate a remaining cooling time, which is a time required until the magnet is cooled to a cooling-completed state, on the basis of the acquired information; and output information indicating the calculated remaining cooling time. According to the tenth aspect, the user can correctly understand the state of the magnet as in the first aspect.

In order to achieve the above-described object, a magnetic resonance imaging system according to an eleventh aspect of the present invention comprises: the operation terminal according to any one of the first to ninth aspects; and the magnetic resonance imaging apparatus. According to the eleventh aspect, the user can correctly understand the state of the magnet as in the first and tenth aspects.

According to a twelfth aspect, the magnetic resonance imaging system according to the eleventh aspect may further comprise a cooling device that cools the magnet; and a thermometer that measures the temperature of the magnet. The magnet may be a superconducting magnet for generating a static magnetic field.

As described above, according to the operation terminal, the method for operating an operation terminal, and the magnetic resonance imaging system according to the aspects of the present invention, the user can correctly understand the state of the magnet.

### BRIEF DESCRIPTION OF THE DRAWINGS

Fig. 1 is a diagram illustrating an overall configuration of a magnetic resonance imaging system according to a first embodiment.
Fig. 2 is a diagram illustrating a configuration of an operation terminal (operation terminal for a local site).
Fig. 3 is a diagram illustrating an example of information recorded in a recording device.
Fig. 4 is a diagram illustrating a configuration of an operation terminal (operation terminal for a service site).
Fig. 5 is a diagram illustrating a use case of an operator (user) of the magnetic resonance imaging system.
Fig. 6 is a flowchart (1/2) illustrating a process in the magnetic resonance imaging system.
Fig. 7 is a flowchart (2/2) illustrating the process in the magnetic resonance imaging system.
Fig. 8 is a diagram illustrating an example of user information.
Fig. 9 is a diagram illustrating a relationship among a state of a magnet, information to be output, an action to be requested to the user, and an operation to be received.
Fig. 10 is a diagram illustrating an example of a cooling curve.
Fig. 11 is a diagram illustrating another example of the cooling curve.
Fig. 12 is a diagram illustrating still another example of the cooling curve.
Fig. 13 is a diagram illustrating a predicted value and an actually measured value of the temperature of the magnet.
Fig. 14 is a diagram illustrating an example of display of a remaining cooling time.
Fig. 15 is a table illustrating an example of discrete display and stepwise display of the remaining cooling time.
Fig. 16 is a table illustrating another example of the discrete display and stepwise display of the remaining cooling time.
Fig. 17 is a table illustrating an example in which the remaining cooling time is displayed discretely and stepwise on a screen.
Fig. 18 is a diagram illustrating a relationship between values of parameters and the state of the magnet.
Fig. 19 is a diagram illustrating changes in a safety check screen.
Fig. 20 is a diagram illustrating an example of display of a remaining excitation time.
Figs. 21A and 21B are diagrams illustrating a relationship between a level of the user and an executable operation.
Fig. 22 is a flowchart illustrating operation restrictions according to the level of the user.
Figs. 23A and 23B are diagrams illustrating an example of an output of safety check information.

### DESCRIPTION OF THE PREFERRED EMBODIMENTS

Hereinafter, preferred embodiments of an operation terminal, a method for operating an operation terminal, and a magnetic resonance imaging system according to the present invention will be described with reference to the accompanying drawings. In addition, in the accompanying drawings, some components may not be illustrated for convenience of description.

### First Embodiment

### Configuration of Magnetic Resonance Imaging System

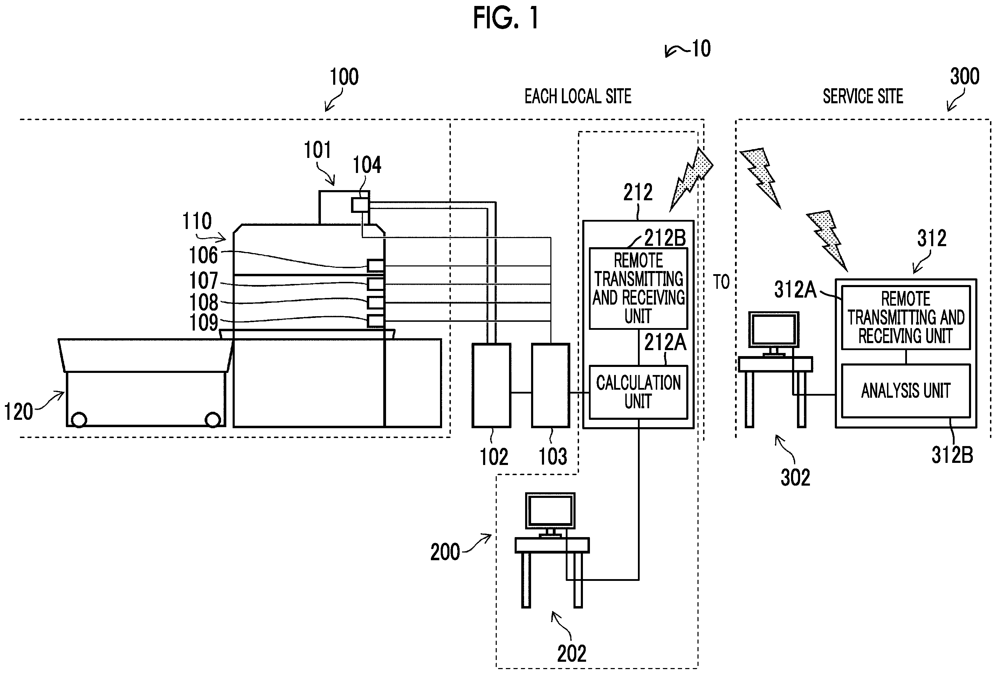

Fig. 1 is a diagram illustrating an overall configuration of a magnetic resonance imaging system 10 (a magnetic resonance imaging system; an MRI system) according to a first embodiment. In Fig. 1, the magnetic resonance imaging system 10 comprises a magnetic resonance imaging apparatus 100 (a magnetic resonance imaging apparatus and an MRI apparatus), an operation terminal 200 (an operation terminal, a first terminal apparatus; an operation terminal for a local site) that is installed close to the magnetic resonance imaging apparatus 100, and an operation terminal 300 (an operation terminal and a second terminal apparatus; an operation terminal for a service site) that is installed away from the magnetic resonance imaging apparatus 100. The magnetic resonance imaging apparatus 100, the operation terminal 200, and the operation terminal 300 can communicate with one another via a network (not illustrated).

Further, the operation terminal 200 can be installed in, for example, an examination room in which the magnetic resonance imaging apparatus 100 is installed or a place which is adjacent to the examination room and where the inside of the examination room can be visually recognized. Hereinafter, the examination room and the place where the inside of the examination room can be visually recognized may be collectively referred to as a "local site". On the other hand, the operation terminal 300 is installed at a service site such as another floor of the same building as the examination room, a building different from the examination room, or a site different from the examination room. The operation terminal 300 (operation terminal for a service site) may communicate with a plurality of magnetic resonance imaging apparatuses 100 and the operation terminal 200 (operation terminal for a local site). In addition, one magnetic resonance imaging apparatus 100 and one operation terminal 200 may communicate with a plurality of operation terminals 300. In addition, the operation terminal 200 is connected to (can communicate with) a control unit 103 which will be described below, but is present separately from the control unit 103. Further, the operation terminal 300 is also connected to the control unit 103, but is present separately from the control unit 103.

The magnetic resonance imaging apparatus 100 comprises a magnet 110 which is a superconducting magnet for generating a static magnetic field. The magnet 110 comprises a vacuum container that is configured to block external heat. A heat shield and a cooling container are provided in the vacuum container, and the inside of the cooling container is maintained in a vacuum. That is, the cooling container has a liquid helium-free configuration. Then, a superconducting coil is provided in the cooling container. The superconducting coil is wound around a bobbin (support member). A refrigerator 101 expands a refrigerant gas compressed by a compressor 102 to generate cold and heat and directly cools the bobbin to cool the superconducting coil wound around the bobbin. The magnetic resonance imaging apparatus 100 may comprise a plurality of refrigerators 101.

A pressure measurement unit 104 and a shield temperature measurement unit 106 are installed in the magnet 110, and all of these units are controlled by the control unit 103. The temperature of the magnet 110 is measured by a magnet temperature measurement unit 107 (a thermometer or a temperature sensor). In addition, an ammeter 108 and a voltmeter 109 are connected to the magnet 110. These devices measure the current and voltage (voltage between lead terminals of the magnet 110) applied to the coil of the magnet 110. Data (including data of the temperature, the current, and the voltage) received from each of the measurement units is transmitted to a processor 212 (calculation unit 212A) by the control unit 103 and is used for the determination of the actual state of the magnet 110 and the like. Further, the magnetic resonance imaging apparatus 100 comprises a gradient magnetic field generation coil and a high-frequency coil (also referred to as a radio frequency (RF) coil) (both not illustrated) in addition to the magnet 110 (superconducting coil).

In addition, the control unit 103 controls the supply of power from a power supply (not illustrated) in response to an instruction from the processor 212 to excite the magnet 110. The magnet 110 can be in any of a plurality of states (a demagnetized state, a cooling state, a cooling-completed state, an exciting state, and an excitation-completed state) depending on the cooling and excitation situations.

Further, the magnetic resonance imaging apparatus 100 comprises an image generation unit (not illustrated) that generates a magnetic resonance image of a subject. The image generation unit may be provided in the operation terminal 200 (for example, may be a function of the processor 212) or may be provided separately from the operation terminal 200. In addition, the magnetic resonance imaging apparatus 100 comprises a bed apparatus 120 on which the subject is placed. The bed apparatus 120 may be attachable to and detachable from a main body of the magnetic resonance imaging apparatus 100.

### Configuration of Operation Terminal for Local Site

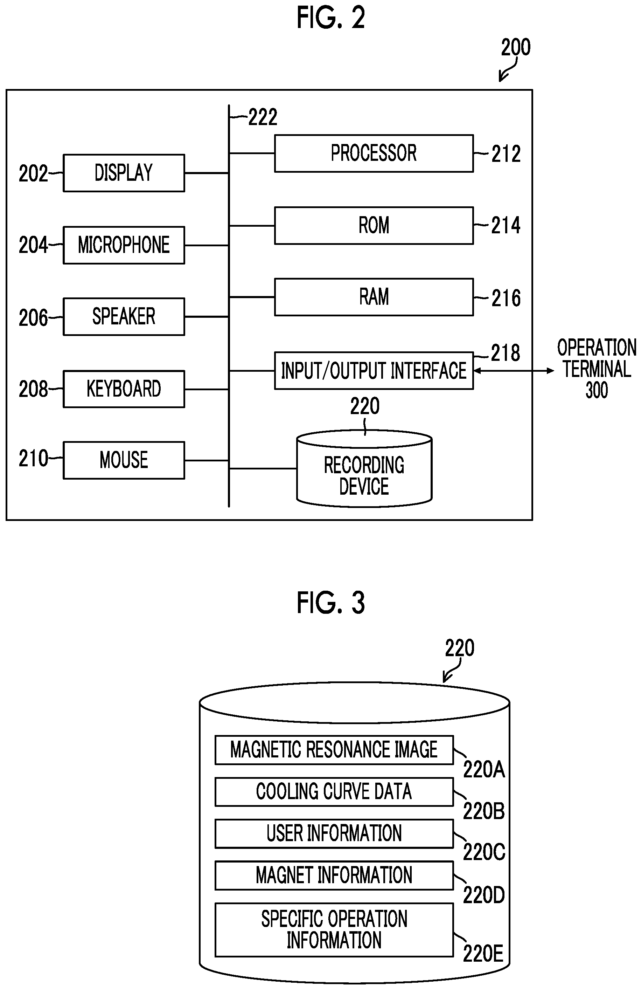

Fig. 2 is a diagram illustrating an example of a configuration of the operation terminal 200 (operation terminal for a local site). As illustrated in Fig. 2, the operation terminal 200 comprises a display 202 (display device), a microphone 204 (voice input device), a speaker 206 (voice output device), a keyboard 208 (input device), and a mouse 210 (input device). The user can input an instruction to the operation terminal 200 using these devices. In addition, the operation terminal 200 can perform the output of the acquired information, the notification of the state of the magnet, and the like using these devices. The display 202 may be configured by a touch panel display and may be used as the input device. The operation terminal 200 can be implemented as a computer comprising the elements illustrated in Fig. 2.

In addition, the operation terminal 200 may comprise a rotating lamp or a warning lamp (may be referred to as a "rotary beacon light" in English) that is called Patlite (registered trademark) or Patlamp and may perform the notification of the state of the magnet, warning, the output of the urgency of refrigerator replacement, and the like using the rotating lamp or the warning lamp. A plurality of rotating lamps or warning lamps having different colors may be provided corresponding to different states of the magnet, importance of warning, the urgency of refrigerator replacement, and the like. For example, the demagnetized state, the cooling state, and the exciting state may be notified or output corresponding to different colors (for example, green, blue, yellow, and red). The same applies to the operation terminal 300.

In addition, the operation terminal 200 comprises the processor 212 (processor), a read only memory (ROM) 214, and a random access memory (RAM) 216. The calculation unit 212A and a remote transmitting and receiving unit 212B are components of the processor 212, and the processor 212 may comprise components or functions other than the calculation unit 212A and the remote transmitting and receiving unit 212B. For example, the processor 212 may have a function of generating an image from the measurement data. The processor 212 performs processes such as determination of the state of the magnet, prediction (calculation) of the remaining cooling time, output of the determination result and the prediction result, and a safety check and start of excitation in a case of exciting the magnet 110, which will be described in detail below. Further, an analysis unit 312B of the operation terminal 300 may perform these processes. The processor 212 transmits the collected data (parameters of the magnet 110) and the processing result thereof (the state of the magnet 110 and the like) to the operation terminal 300 via an input/output interface 218 and a network (not illustrated) as necessary.

In addition, the calculation unit 212A (processor 212) calculates each received data item, outputs a command to turn on or off the compressor 102 to the control unit 103 on the basis of the calculation result, and controls the pressure in a constant range such that the output of the heater approaches 0. The calculation unit 212A displays each acquired data item and the urgency of the refrigerator replacement on the display 202 of the operation terminal 200 at each local site. In addition, the calculation unit 212A transmits each acquired data item and the urgency of the refrigerator replacement to a remote transmitting and receiving unit 312A (processor 312) of the operation terminal 300 (operation terminal for a service site) via a communication path, such as wireless communication or a data transmission path, using the remote transmitting and receiving unit 212B (processor 212). The remote transmitting and receiving unit 312A receives the data via an input/output interface 318 and transmits the received data to an analysis unit 312B (processor 312). Similarly, the analysis unit 312B analyzes data received from facilities (the magnetic resonance imaging apparatus 100 and the operation terminal 200) at other local sites and analyzes the optimal replacement timing of the refrigerator. The processor 312 may perform processes such as determination of the state of the magnet, prediction (calculation) of the remaining cooling time, output of the determination result and the prediction result, and a safety check and start of excitation in a case of exciting the magnet 110. In addition, the analysis unit 312B can display the received data, the analysis data, a message to the user, and the like on the display 302 of the operation terminal 300 or output the data via a speaker 306.

Each unit of the operation terminal 200 is connected via a bus 222.

### Example of Information Recorded in Recording Device

A recording device 220 (non-transitory tangible recording medium) comprises a non-transitory tangible recording medium, such as a magnetic disk, an optical disk, or a semiconductor memory, and a control unit therefor and records various types of information. Fig. 3 is a diagram illustrating an example of the information recorded in the recording device 220. In the example illustrated in Fig. 3, a magnetic resonance image 220A, cooling curve data 220B, user information 220C, magnet information 220D, and specific operation information 220E are recorded in the recording device 220. Other information may be recorded in the recording device 220.

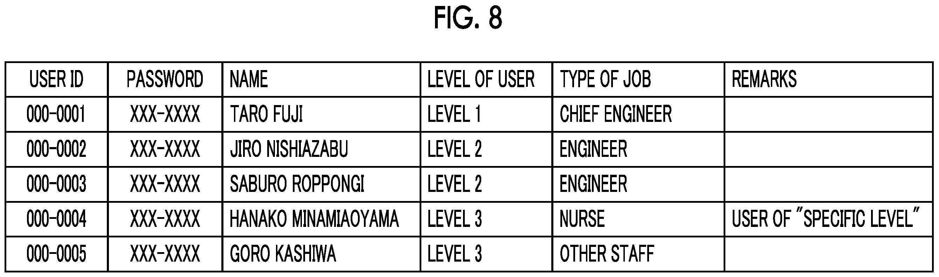

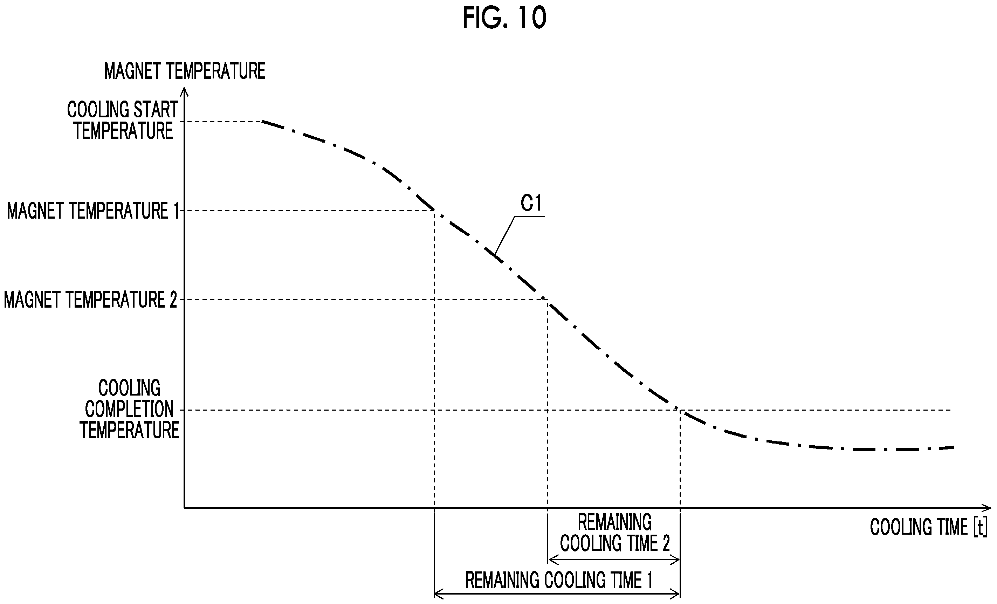

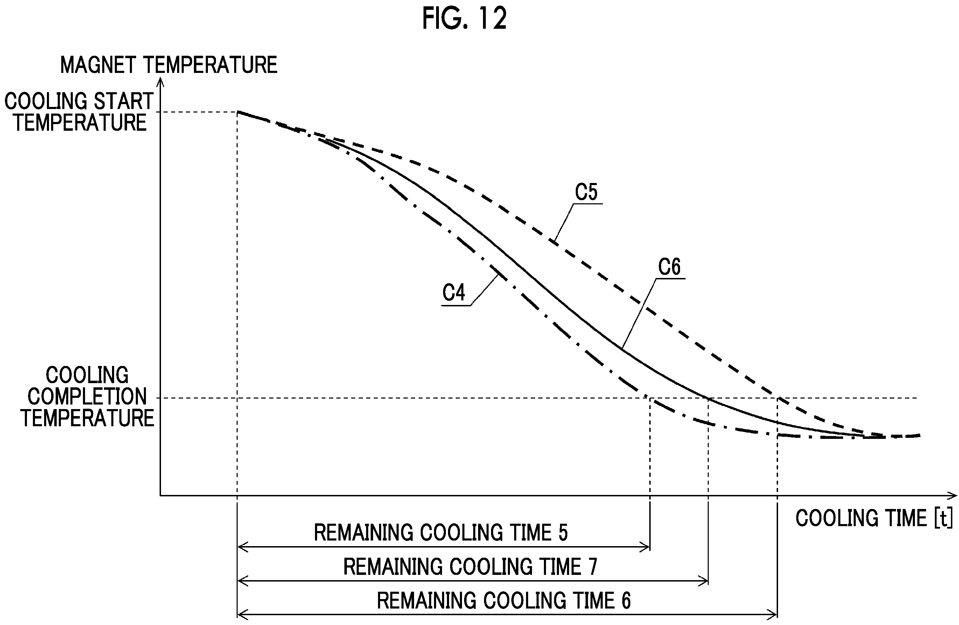

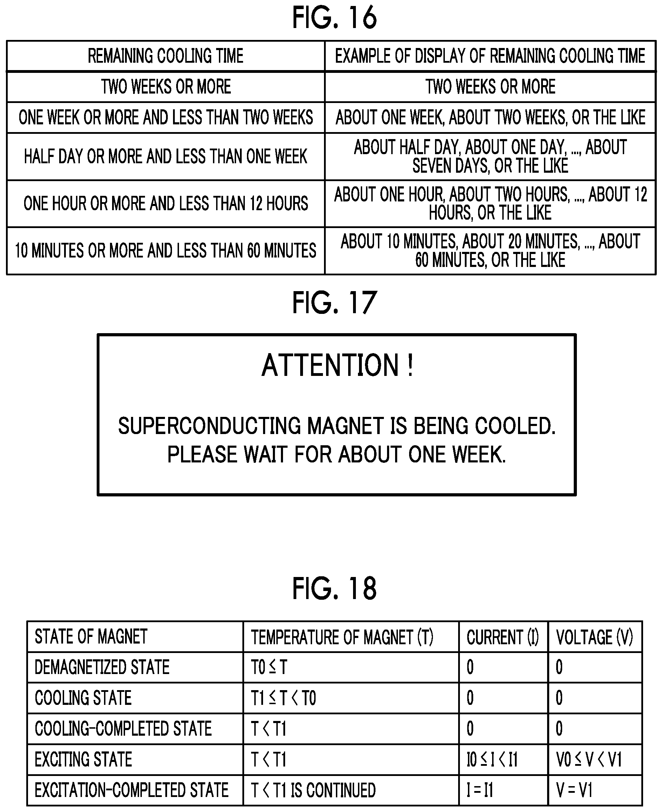

The magnetic resonance image 220A is an image obtained by imaging the subject with the magnetic resonance imaging apparatus 100. The cooling curve data 220B is data of a cooling curve indicating a relationship between the time from the start of the cooling of the magnet 110 (the superconducting magnet for generating a static magnetic field) and the temperature of the magnet 110, which has been generated on the basis of the actually measured values, and is used for predicting (calculating) the remaining cooling time (see Fig. 12 and the like which will be described below). The user information 220C is information (see Fig. 8 and the like which will be described below) in which identification information of the user of the operation terminal 200 and information indicating the type of job of the user divided into a plurality of levels have been associated with each other. The magnet information 220D is information (see Fig. 10 and the like which will be described below) in which values of parameters (temperature, a current, a voltage, and the like) related to the magnet 110 have been associated with the states that the magnet 110 can be in. The specific operation information 220E (specific operation information) is information (see Fig. 18 and the like which will be described below) in which the level (type of job) of the user and the operation that can be executed by the user at each level have been associated with each other. A process using these information items will be described in detail below.

### Configuration of Operation Terminal for Service Site

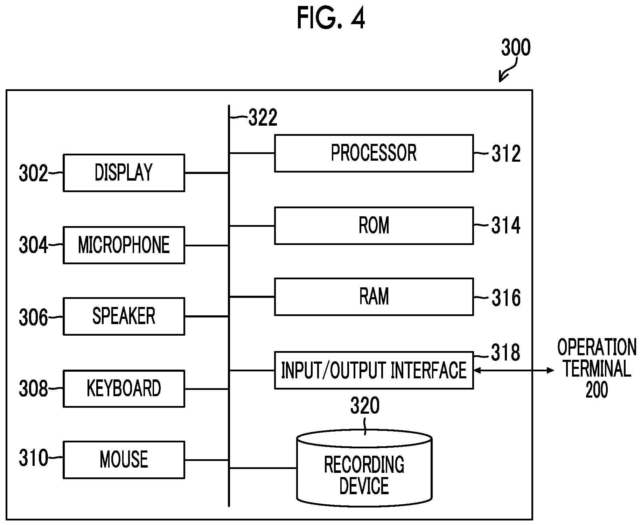

Fig. 4 is a diagram illustrating a configuration of the operation terminal 300 (operation terminal for a service site). The operation terminal 300 comprises a display 302 (display device), a microphone 304 (voice input device), the speaker 306 (voice output device), a keyboard 308 (input device), and a mouse 310 (input device) similarly to the operation terminal 200 (operation terminal for a local site). The user can input an instruction to the operation terminal 300 using these devices, and the operation terminal 300 can perform the output of the acquired information, the notification of the state of the magnet, and the like using these devices. The display 302 may be configured as a touch panel display and may be used as an input device. Each unit of the operation terminal 300 is connected via a bus 322.

In addition, the operation terminal 300 comprises a processor 312 (processor), a ROM 314, and a RAM 316. The remote transmitting and receiving unit 312A and the analysis unit 312B are components of the processor 312. The operation terminal 300 can analyze the urgency of the refrigerator replacement and the replacement timing on the basis of the data collected from the operation terminal 200 and display the analysis result on the display 302, using the processor 312. The processor 312 may have a function of generating an image from measurement data similarly to the processor 212. The recording device 320 comprises a non-transitory tangible recording medium, such as a magnetic disk, an optical disk, or a semiconductor memory, and a control unit therefor and records various types of information. The information recorded in the recording device 320 may be the same as or different from the information recorded in the recording device 220. Information received from a plurality of operation terminals 200 may be recorded in the recording device 320.

In addition, the user can perform the same operation as the operation terminal 200 using the operation terminal 300.

### Configuration of Processor in Operation Terminal

In the present embodiment, hardware structures of the processor 212 and the processor 312 executing the above-mentioned processes are, for example, various processors described below. The "various processors" include, for example, a central processing unit (CPU) which is a general-purpose processor executing software (program) to function as various processing units, a programmable logic device (PLD), such as a field programmable gate array (FPGA), which is a processor whose circuit configuration can be changed after manufacture, and a dedicated electric circuit, such as an application specific integrated circuit (ASIC), which is a processor having a dedicated circuit configuration designed to perform a specific process.

The processor 212 and the processor 312 may be configured by one of the various processors or may be configured by two or more processors of the same type or different types (for example, a plurality of FPGAs or a combination of a CPU and an FPGA). In addition, a plurality of processing units (including the calculation unit 212A, the remote transmitting and receiving unit 212B, the remote transmitting and receiving unit 312A, and the analysis unit 312B) may be configured by one processor. A first example of the configuration in which a plurality of processing units are configured by one processor is an aspect in which one processor is configured by a combination of one or more CPUs and software and functions as a plurality of processing units. A representative example of this aspect is a client computer or a server computer. A second example of the configuration is an aspect in which a processor that implements the functions of the entire system including a plurality of processing units using one integrated circuit (IC) chip is used. A representative example of this aspect is a system-on-chip (SoC). As described above, various processing units can be configured by using one or more of the various processors as a hardware structure.

In addition, more specifically, the hardware structure of the various processors is an electric circuit (circuitry) obtained by combining circuit elements such as semiconductor elements. Further, in a case where various processors are operated, programs and data recorded in non-transitory tangible recording media such as the ROMs 214 and 314, can be referred to, and recording media, such as the RAMs 216 and 316, and internal memories can be used as transitory work areas during the operation.

### Use Case of Operator

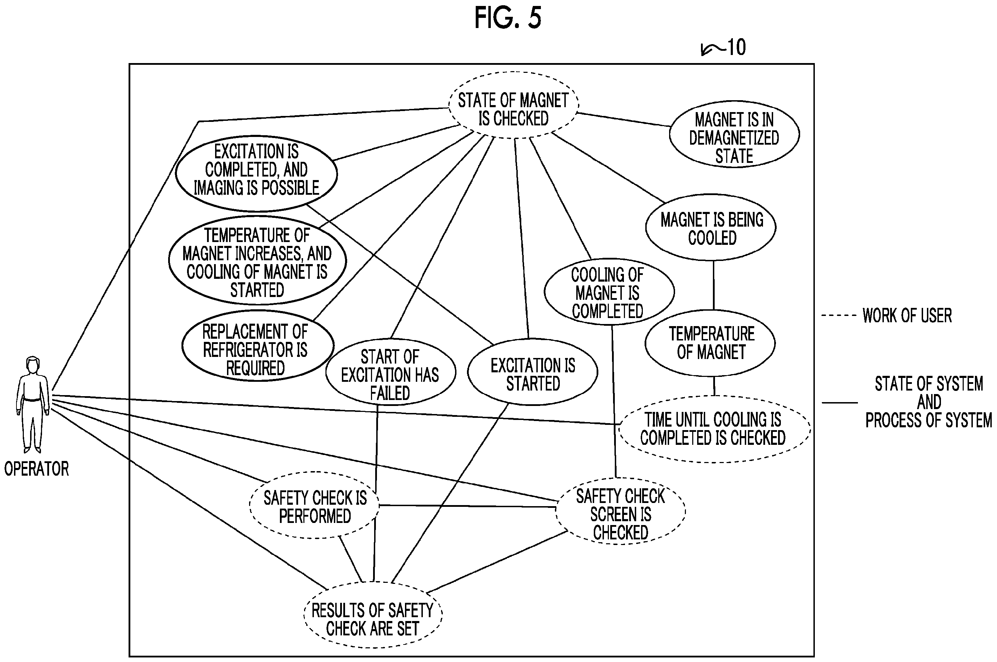

Fig. 5 is a diagram illustrating a use case of an operator (user) of the magnetic resonance imaging system 10. This use case shows a relationship among the state of the magnetic resonance imaging system 10, the process in the magnetic resonance imaging system 10, and the operation of the user corresponding to the state and the process. In Fig. 5, a solid line portion indicates the state of the system and the process (including the output of information) of the system, and a dotted line portion indicates the operation (work) of the operator.

### Process in Magnetic Resonance Imaging System

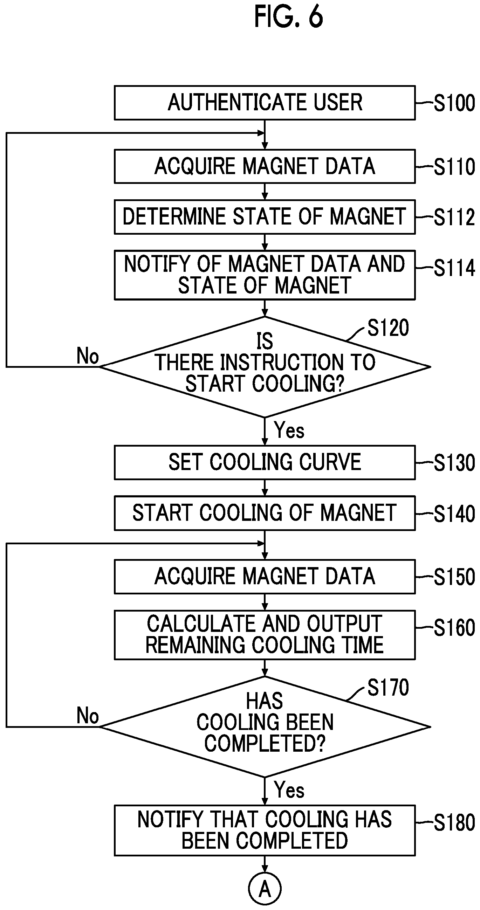

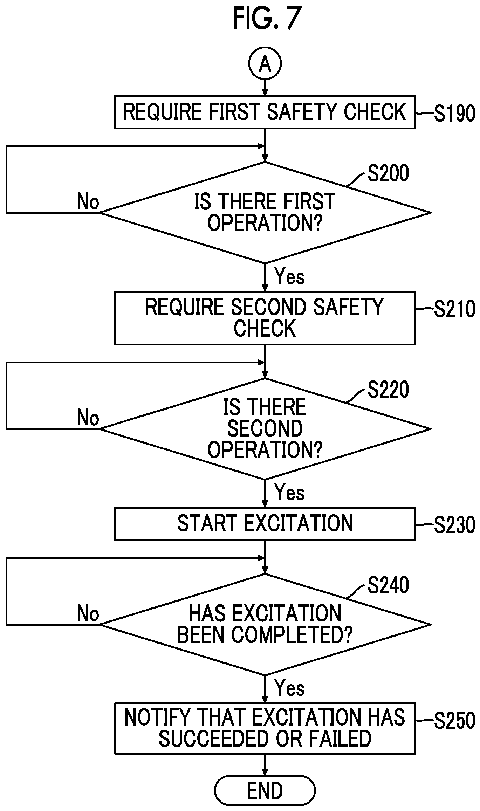

Next, an aspect of the process (method for operating the magnetic resonance imaging system 10) in the magnetic resonance imaging system 10 will be described. Figs. 6 and 7 are flowcharts illustrating the process in the magnetic resonance imaging system 10. Further, an aspect in which the operation terminal 200 (the operation terminal for a local site and the first terminal apparatus) mainly performs the process will be described below. However, the operation terminal 300 (the operation terminal for a service site and the second terminal apparatus) may perform the process.

### Authentication of User

The processor 212 of the operation terminal 200 authenticates the user (Step S100). The processor 212 can compare the information (a login ID, a password, and the like) input through the device, such as the keyboard 208, the mouse 210, or the microphone 204, with the user information 220C (see Fig. 3) recorded in the recording device 220 to authenticate the user. As illustrated in Fig. 8, the user information 220C is information in which the identification information of the user of the operation terminal 200 has been associated with information indicating the type of job of the user divided into a plurality of levels. In addition, a barcode reader or a scanner may be provided in the operation terminal 200 to read information recorded in an employee card, a staff card, or the like, and the read information may be used for the authentication. Biometric authentication (for example, authentication of a fingerprint, a blood vessel pattern, an iris, a voiceprint, and the like) of the user may be performed. In addition, in the magnetic resonance imaging system 10, it is possible to restrict the operation that can be executed by the user according to the level (type of job) of the user or to set the role of the operation terminal according to the authentication result (which will be described below).

### State of Magnet

The processor 212 acquires magnet data (the magnet information 220D in Fig. 3; first information) from the magnetic resonance imaging apparatus 100 (Step S110) and determines which of a plurality of states that the magnet 110 can be in the actual state of the magnet 110 is (Step S112). The processor 212 can notify the user of the acquired magnet data and the determined actual state of the magnet 110 using the display 202, the speaker 206, or the above-mentioned rotating lamp or warning lamp (not illustrated) (Step S 114). The magnet data (first information) is the values of the parameters related to the magnet 110 and includes at least one of the temperature of the magnet 110, the current flowing through the magnet 110, or the voltage between the lead terminals of the magnet 110. In addition, the plurality of states that the magnet 110 can be in are a demagnetized state, a cooling state, a cooling-completed state, an exciting state, and an excitation-completed state, and the actual state is any one of the plurality of states. Further, the demagnetized state and the cooling state may be collectively referred to as a "cooling state".

The magnet data can be measured by the magnet temperature measurement unit 107, the ammeter 108, and the voltmeter 109. As described above with reference to Fig. 3, the values of the parameters related to the magnet 110 and the states of the magnet 110 corresponding to the values of the parameters are recorded in the recording device 220 in association with each other (magnet information 220D; see an example illustrated in Fig. 10). The processor 212 can determine the actual state of the magnet 110 on the basis of the measured data and the magnet information 220D. Further, the processor 212 may acquire parameters other than the magnet data. In this case, after acquiring the magnet data (the parameters indicating the states of the magnet 110) and determining the state of the magnet 110, the processor 212 can determine "what parameters to acquire as the parameters other than the magnet data" according to the state of the magnet 110.

The processor 212 can acquire the values of the parameters at a determined time interval to perform the determination. In a case where the actual state of the magnet 110 has been changed (for example, in a case where the cooling state has been changed to the cooling-completed state or in a case where the exciting state has been changed to the excitation-completed state), the processor 212 can send a notification. In a case where the state of the magnet 110 is abnormal, the processor 212 may send a notification. In addition, the processor 212 can perform the notification using at least one of the display 202 (display device) or the speaker 206 (voice output device).

Further, it is preferable that the processor 212 acquires the values of the parameters in real time (without time delay), determines the state of the magnet 110, and sends a notification. In addition, the processor 212 can notify the remote transmitting and receiving unit 312A (processor 312) of the operation terminal 300 (operation terminal for a service site) of the state of the magnet 110, and the remote transmitting and receiving unit 312A can display the notified state of the magnet 110 on the display 302, output the notified state of the magnet 110 as voice from the speaker 306, or output the notified state of the magnet 110 using the above-mentioned rotating lamp or warning lamp as an aspect of the notification.

The processor 212 continues the acquisition of the data, the determination of the state of the magnet 110, and the notification until an instruction to start the cooling of the magnet 110 is issued (until the result in Step S120 is "YES"). In a case where the magnet 110 is in the demagnetized state, the processor 212 notifies (performs display output or voice output) that the magnet 110 is in the demagnetized state.

### Action Corresponding to State of Magnet

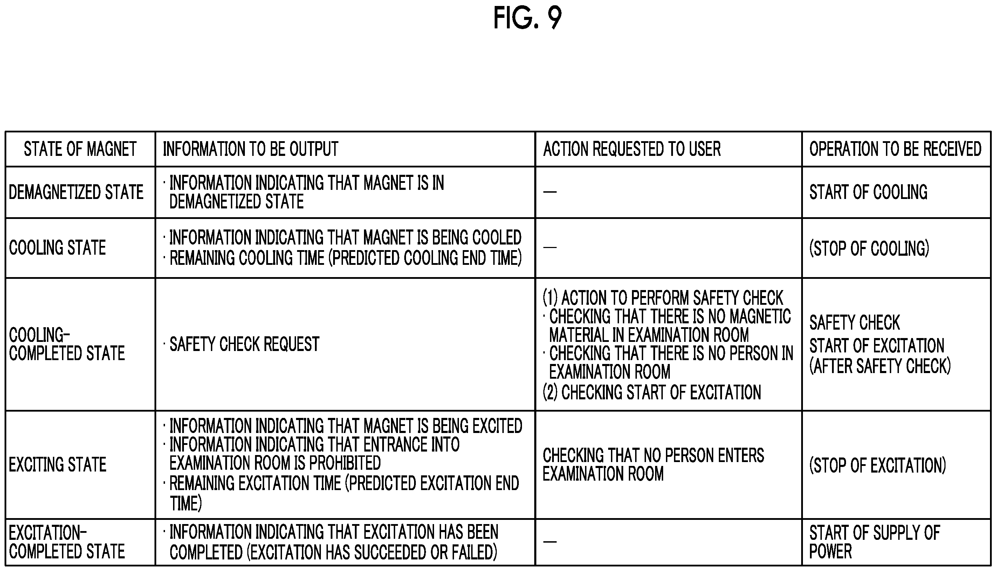

In addition, the processor 212 receives an operation corresponding to the actual state of the magnet 110 and transmits an instruction corresponding to the received operation to the magnetic resonance imaging apparatus 100. Fig. 9 is a table illustrating a relationship among the state of the magnet, the information output by the processor 212, the action requested to the user, and the operation received in a case where the action is executed, and information of the relationship is recorded in the recording device 220. The processor 212 determines the action requested to the user according to the actual state of the magnet for at least some of the states of the plurality of states that the magnet 110 can be in with reference to the information in the table recorded in the recording device 220. Further, Fig. 9 illustrates a case where the user is requested to perform an action for the cooling-completed state and the exciting state. However, the processor 212 may request the user to perform an action for all of the plurality of states that include other states and that the magnet 110 can be in.

### Cooling of Superconducting Magnet

### Start of Excitation After Liquid Helium-Free Cooling

In the technique according to the related art using liquid helium, the superconducting magnet is cooled only by pressure (atmospheric pressure). However, a liquid helium-free operation makes it necessary to cool the superconducting magnet with power instead of pressure (atmospheric pressure) and to maintain a superconducting state. However, in a case where a power supply for the superconducting magnet is turned off for maintenance or the like, cooling is stopped, and the magnetic field becomes zero (demagnetized state). As a result, the temperature of the superconducting magnet increases. In order to return this state to the normal superconducting state, it is necessary to first cool the superconducting magnet and then to start the excitation. In the present embodiment, a safety check is performed during this excitation, as will be described below. In addition, the user can perform the excitation not only using the operation terminal for a local site but also using a remote operation terminal (service site or the like).

### Setting of Cooling Curve

In a case where the user inputs an instruction to start the cooling of the magnet 110 to the operation terminal 200 (YES in Step S120), the processor 212 sets a cooling curve used for predicting (calculating) the remaining cooling time in response to the instruction (Step S130). As illustrated in Fig. 10, the "cooling curve" is information which indicates a relationship between the time from the start of the cooling of the magnet 110 and the temperature of the magnet 110 and which has been generated on the basis of the actually measured value (cooling curve data 220B in Fig. 3), and the "remaining cooling time" is the time (remaining time) required until the magnet 110 is cooled to the cooling-completed state. In addition, the "cooling-completed state" is a state in which the superconducting state of the magnet 110 is maintained and the excitation of the magnet 110 can be started. In the example illustrated in Fig. 10, in a cooling curve C1, remaining cooling time 1 corresponds to magnet temperature 1, and remaining cooling time 2 corresponds to magnet temperature 2.

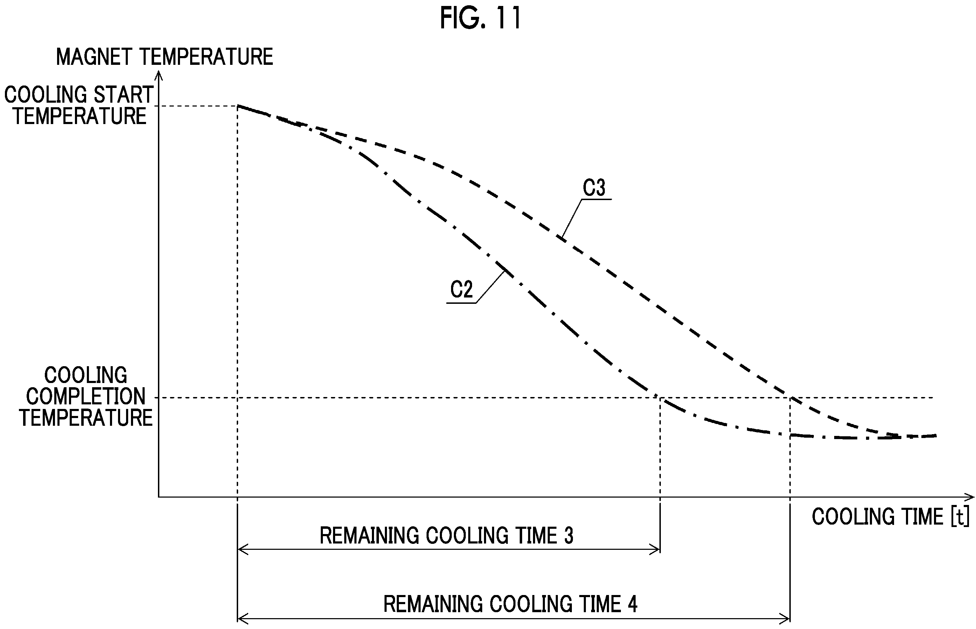

Fig. 11 is a diagram illustrating another example of the cooling curve and illustrates cooling curves C2 and C3 for refrigerators 1 and 2 (cooling devices of different types). A total cooling time (from the start of cooling to the completion of cooling) in a cooling curve C2 is remaining cooling time 3, and a total cooling time in a cooling curve C3 is remaining cooling time 4. In addition, Fig. 12 is a diagram illustrating still another example of the cooling curve and illustrates an aspect in which a cooling curve C6 one year after the start of use is calculated by interpolating a cooling curve C4 at the start of use and a cooling curve C5 three years after the start of use for refrigerator 1. The total cooling times corresponding to the cooling curves C4, C5, and C6 are remaining cooling times 5, 6, and 7, respectively.

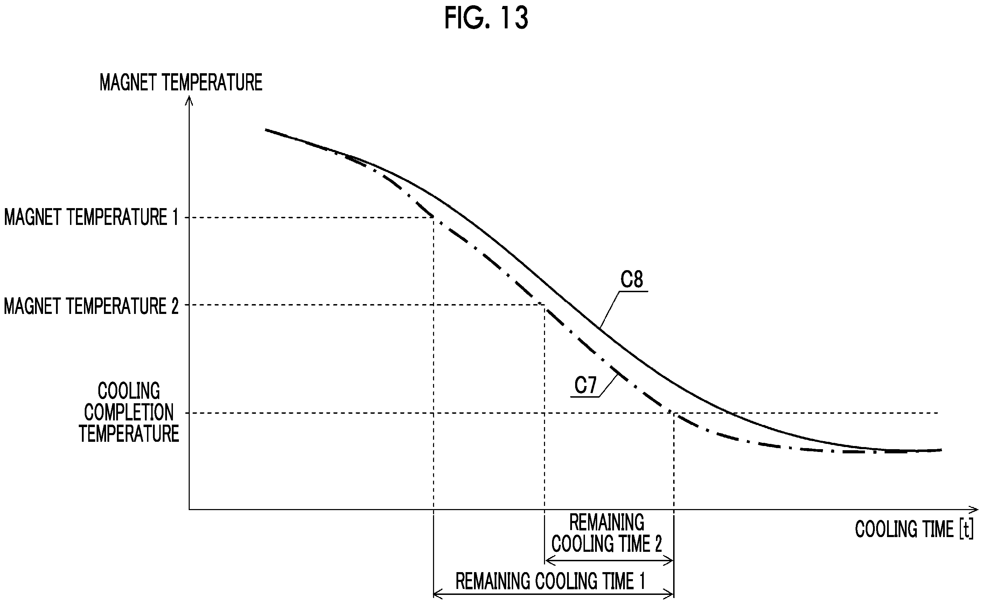

As described above, in the magnetic resonance imaging system 10, it is preferable to store data of a plurality of cooling curves corresponding to the type of the cooling device cooling the magnet 110 and a change in the cooling device over time in the recording device 220. It is preferable that the processor 212 interpolates the plurality of cooling curves according to the type of the cooling device and the change in the cooling device over time to predict (calculate) the remaining cooling time. This process makes it possible to accurately predict the remaining cooling time. In addition, the processor 212 can newly generate a cooling curve on the basis of the actually measured value of the temperature of the magnet 110 and store the data of the generated cooling curve in the recording device 220. For example, as illustrated in Fig. 13, a cooling curve C8 based on the actually measured value can be generated for a cooling curve C7 (predicted curve) and stored in the recording device 220. A method used for generating a new cooling curve based on the actually measured value is not particularly limited. For example, a machine learning method, such as a non-linear least squares method, can be used. In the generation of a new cooling curve, the processor 212 may remove an abnormal value included in the actually measured values.

Further, the processor 212 can display these cooling curves on the display 202 (display device).

### Calculation and Output of Remaining Cooling Time

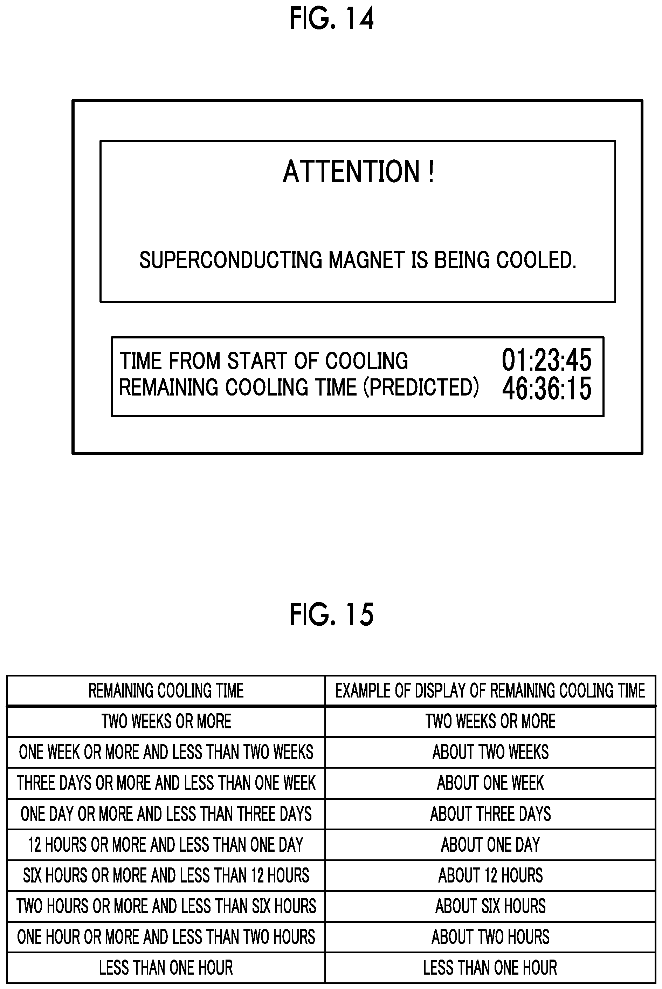

The processor 212 starts the cooling of the magnet 110 using the compressor 102 and the control unit 103 in response to the instruction to start cooling (Step S140) and acquires the magnet data (Step S150). The processor 212 may start the cooling of the magnet 110 in response to the operation of the operation terminal 200 by the user or may automatically start the cooling without the operation of the user in a case where a necessary condition is satisfied. The processor 212 can regard that the user has performed the operation or that the necessary condition has been satisfied as the "instruction to start cooling". Then, the processor 212 calculates the remaining cooling time using the cooling curve set in Step S 130 and the acquired magnet data and outputs the calculated remaining cooling time (Step S160). Fig. 14 is a diagram illustrating an example of the display of the remaining cooling time (a numerical value is an example and does not accurately reflect the actual cooling time of the magnetic resonance imaging apparatus). Not only the remaining cooling time but also the timing when the excitation can be started may be displayed. The display of the data enables the user to easily ascertain the remaining cooling time or the timing when the excitation can be started. The processor 212 may display the set cooling curve or the measured temperature of the magnet 110 (numerical display, graph display, or the like) in addition to the remaining cooling time. The display of the data enables the user to accurately ascertain the state of the magnet 110, the aspect of cooling, or the like.

### Discrete Display and Stepwise Display of Remaining Cooling Time

The remaining cooling time can be displayed discretely and/or stepwise. For example, the remaining cooling time may be displayed (on the display 202) as illustrated in Fig. 15. In the example illustrated in Fig. 15, the processor 212 displays the remaining cooling time (information indicating the remaining cooling time) discretely and stepwise according to the remaining cooling time. In addition, as the remaining cooling time approaches zero, a small granularity is determined, and the remaining cooling time is output with the determined granularity. The "granularity" is an output unit of information. The granularity can be smaller as the remaining cooling time is shorter. Specifically, in a case where the calculated remaining cooling time is one week or more, the processor 212 displays "week" as the granularity (unit). Similarly, in a case where the remaining cooling time is one day or more and less than one week, the processor 212 displays "day" as the granularity. In a case where the remaining cooling time is less than one day, the processor 212 displays "hour" as the unit. In addition, in a case where the remaining cooling time is "one week or more and less than two weeks", the processor 212 displays "about two weeks" which is an upper limit value. Furthermore, the phrase "about" is added to indicate that the displayed remaining cooling time is approximate. Other phrases "approximately", "roughly (around)", or "nearly" may be used as the phrase indicating the approximate time.

Fig. 16 is a diagram illustrating another example of the discrete display and the stepwise display. In the example illustrated in Fig. 16, the processor 212 rounds the numerical value of the remaining cooling time and displays the approximate time. The numerical value can be "rounded", for example, by rounding-off, rounding-up, or adopting an upper limit value of a range. For example, in a case where the calculated remaining cooling time is 10 days, it can be displayed as "about two weeks". Further, even in the example illustrated in Fig. 16, as the remaining cooling time approaches zero, a smaller granularity is determined, and the remaining cooling time is output with the determined granularity as in the example illustrated in Fig. 15.

Fig. 17 is a diagram illustrating an example in which the remaining cooling time is discretely displayed on the screen. As described above, the phrase "about" is added to indicate that the displayed remaining cooling time is approximate.

For example, even in a case where the difference in the remaining cooling time is one hour, there is little difference between "one week left" and "one week left + one hour", but there is a large difference between "one hour left" and "two hours left". Therefore, it is preferable to perform the above-mentioned discrete display or stepwise display. In addition, information indicating a correspondence relationship between the remaining cooling time and the display time illustrated in Figs. 15 and 16 is recorded in the recording device 220, and the processor 212 can perform this display with reference to the information at the calculated remaining cooling time. The same applies to the operation terminal 300. The user of the operation terminal 200 or 300 may set the granularity of display.

The processor 212 repeats the acquisition of the magnet data and the calculation and output of the remaining cooling time until the cooling is completed (until the result in Step S170 is "YES"). The processor 212 can set "temperature T < T1 is continued for a predetermined time or longer" (see Fig. 18) as a requirement for cooling completion. In a case where the cooling is completed (YES in Step S170), the processor 212 notifies that the cooling has been completed (Step S180). The notification may be a screen output illustrated in Fig. 14 and Fig. 17 or may be a voice output.

Further, in a case where some abnormalities are detected during the cooling, the user of the operation terminal 200 or 300 can perform an operation of interrupting or stopping the cooling.

### Safety Check in Case Where Excitation Is Started

### Two-Stage Safety Check: First Operation

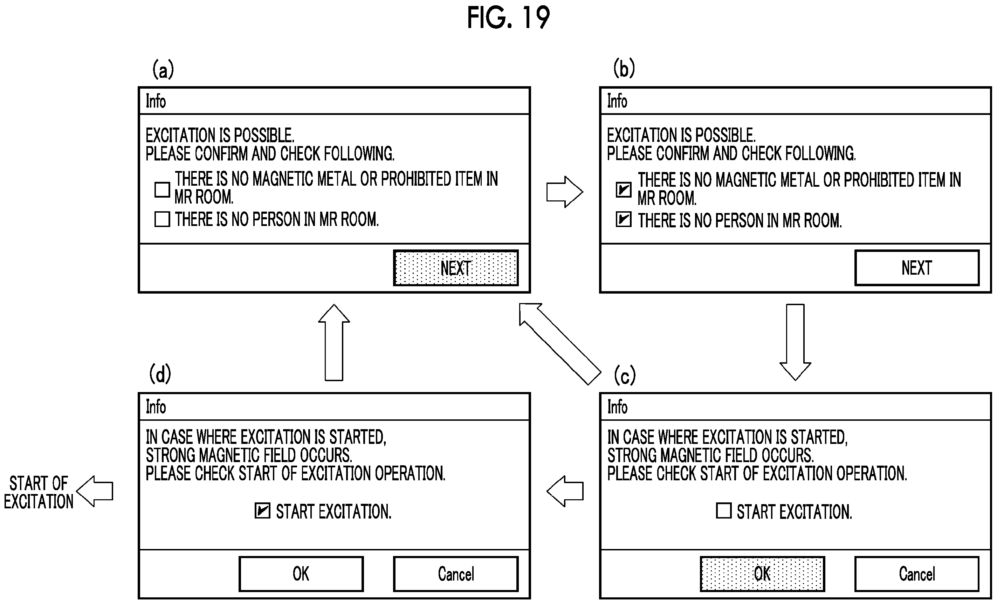

In the magnetic resonance imaging system 10 according to the present embodiment, after the cooling is completed, a safety check is performed, and then excitation is started. It is preferable that this safety check is performed in two stages as described below. Fig. 19 is a diagram illustrating an example of a two-stage safety check screen. First, in a case where the state of the magnet 110 is the cooling-completed state by the process up to Step S180, the processor 212 displays a screen prompting the user to perform a first operation (first safety check operation) on the display 202 (Step S190). (a) of Fig. 19 illustrates an example of a screen prompting the first operation (an example of the output of second information). In a case where the user does not check two check boxes after checking that "there is no magnetic metal or prohibited item in the MR room (in the examination room)" and that "there is no person in the MR room", a "Next" button is not capable of being pressed. That is, the check of the check box and the pressing of the "Next" button constitute the first operation. The user can check the check box and press the button using the mouse 210 (the same applies to the safety check which will be described below). In addition, instead of the display on the display 202 or in addition to the display on the display 202, a message may be output as voice (an example of the output of the second information) from the speaker 206 to prompt the user to perform the first operation.

In addition, Fig. 19 illustrates an example in which the safety check is performed by the operation (an example of the first operation) through the screen of the display 202 (display device). However, the user may perform the operation of inputting voice through the microphone 204 to perform the safety check. The operation by the voice input can be performed by, for example, the utterance of a specific phrase (another example of the first operation), such as "It has been checked that there is no magnetic material" or "It has been checked that there is no person". As described above, the processor 212 can receive, as the safety check operation, at least one of the operation through the screen of the display device or the operation by the voice input. Further, in this case, it is assumed that the processor 212 has a voice recognition function.

In addition, for the above-described safety check, a magnetic material detection device may be provided outside the examination room, at an entrance, or the like, may detect the magnetic resonance imaging apparatus 100 and a magnetic material (for example, a machine, an apparatus, a tool, or a possession article of the subject used in and around the examination room) in the vicinity of the magnetic resonance imaging apparatus 100, and may output a detection result (first auxiliary information). Further, the magnetic material detection device may be provided in the examination room. In this case, for example, it is possible to use a device that detects the magnetic material on the basis of a change in the voltage between the current lead terminals of the superconducting coil. The processor 212 or the processor 312 may be configured to have this magnetic material detection function. The output may be display output to the display 202 or voice output to the speaker 206. In a case where the display output is performed, the name of a typical magnetic material (for example, the name of a tool such as a magnetic material driver), an image of the tool, or an illustration of the tool may be displayed on the display 202, and information of the magnetic material may be used as auxiliary information (first auxiliary information) for checking the presence of the magnetic material. Further, a camera that images the magnetic resonance imaging apparatus 100 and the vicinity of the magnetic resonance imaging apparatus 100 may be installed, and a captured image (second auxiliary information) may be displayed on the display 202 and used as the auxiliary information (second auxiliary information) in a case of performing the safety check. In the magnetic resonance imaging system 10, it is preferable to output at least one of the first auxiliary information or the second auxiliary information in a case of performing the safety check, and the user can perform the safety check quickly and easily with the first auxiliary information and the second auxiliary information.

### Two-Stage Safety Check: Second Operation

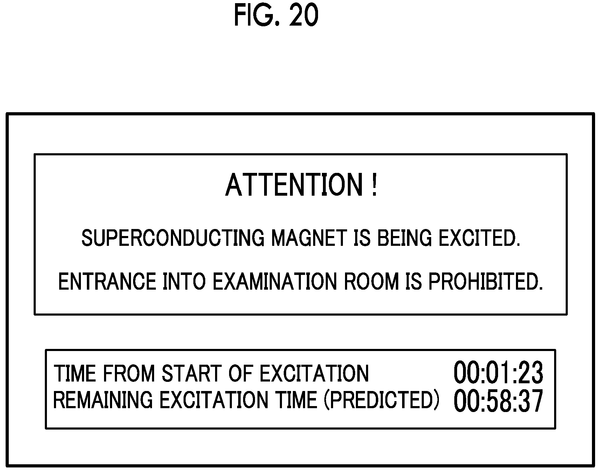

In a case where the user checks the two check boxes in the state illustrated in (a) of Fig. 19, the color of the button is changed such that the button can be pressed (or tapped; the same applies hereinafter) as illustrated in (b) of Fig. 19. In a case where the user presses the button in this state (YES in Step S200), the processor 212 displays a screen (an example of the output of the second information) prompting the user to perform the second operation (second safety check operation) on the display 202 (Step S210). Specifically, the processor 212 displays a screen illustrated in (c) of Fig. 19 on the display 202. In a case where the user checks a check box of "start excitation", the color of an OK button is changed such that the user can press the OK button as illustrated in (d) of Fig. 19. That is, the check of the check box and the pressing of the OK button constitute the second operation similarly to the first operation. In a case where the user presses the OK button in this state, the processor 212 instructs the magnetic resonance imaging apparatus 100 to start the excitation, and the excitation is started in response to this instruction (Step S230). The excitation is automatically performed along a predetermined sequence. During the excitation, as illustrated in Fig. 20, it is preferable to display the remaining excitation time (predicted value) and a message indicating that the entrance into the examination room is prohibited. This display of the remaining excitation time enables the user to ascertain the time when the examination can be started. Further, the value of the remaining excitation time illustrated in Fig. 20 is an example and does not accurately reflect the actual remaining excitation time of the magnetic resonance imaging apparatus. In addition, the processor 212 may perform discrete display or stepwise display on the remaining excitation time in the same manner as the remaining cooling time or may change the granularity of display.

According to the present embodiment, as described above, the two-stage safety check is performed, and excitation is not started unless the user checks all items and presses the OK button. Therefore, safety is ensured, and it is possible to prevent the presence of the magnetic material in the vicinity of the magnetic resonance imaging apparatus 100 from affecting the quality of the magnetic resonance image.

### Setting of Aspect of Notification Corresponding to State of Magnet and the Like

Further, it is preferable that the processor 212 sets the aspect of the notification on the basis of the state of the magnet 110 or the content of the action requested to be performed by the user. For example, it is considered that, for the notification in a state in which the safety check is required and caution is required for the operation as in a case where the magnet 110 is excited, notification and display aspects (for example, the presence or absence, type, or size of characters, symbols, figures, and icons or a screen color) or a voice output aspect (volume, pitch, an output pattern, or the like) in other states are changed to increase the degree of attention.

### Cancel of Safety Check

In the above-described safety check, in a case where the user presses a "cancel" button in the state illustrated in (c) of Fig. 19, the processor 212 returns to Step S190 and displays the screen illustrated in (a) of Fig. 19 on the display 202 to prompt the user to perform the first operation again. That is, in a case where the second operation is canceled, the processor 212 does not instruct the magnetic resonance imaging apparatus 100 to start the excitation and prompts the user to perform the first operation.

### Completion of Excitation

The processor 212 determines whether or not the excitation has been completed (Step S240). In a case where the excitation has been completed (YES in Step S240), the processor 212 notifies that the excitation has been completed (the excitation has succeeded or failed) by display or voice (Step S250). The completion (success) of the excitation makes it possible to image the subject with the magnetic resonance imaging apparatus 100.

Further, in a case where any abnormality is detected during the excitation, the user of the operation terminal 200 or 300 can perform the operation of interrupting or stopping the excitation. In addition, a failure in maintaining a low temperature state leads to the loss of the magnetic field. Therefore, even after the end of the examination, the supply of power is maintained except for a period, such as maintenance, and the cooling state and the excitation state are maintained.

### Restriction of Operation According to Type of Job of User

### Association Between Type of Job of User and Operation Executable by User

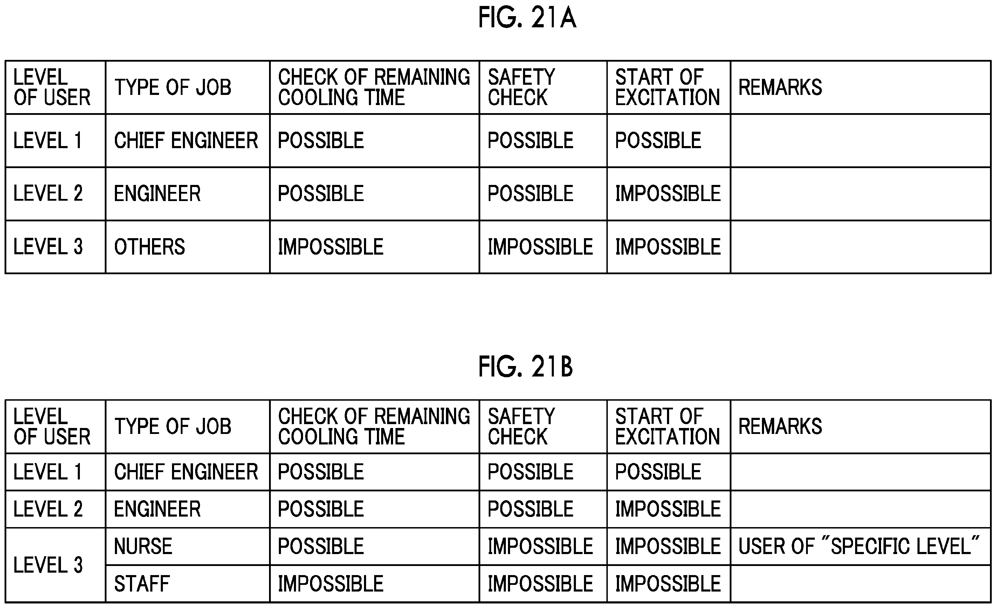

In the magnetic resonance imaging system 10 according to the first embodiment, the operations that can be executed after the user logs in may be restricted according to the type of job (level) of the user. In a case where the restrictions are imposed on the executable operations as described above, for example, in the operation terminal 200, the identification information of the user of the operation terminal 200, information indicating the types of jobs of the users divided into a plurality of levels, and information indicating the operations that can be executed by the users belonging to each type of job can be stored in the recording device 220 in association with each other. For example, the relationship between the identification information of the user and the level and type of job of the user can be associated with each other as illustrated in Fig. 8. In addition, for example, the operations that can be executed by the users belonging to each type of job can be defined as illustrated in tables of Figs. 21A and 21B. These information items can be recorded as the user information 220C or the specific operation information 220E (see Fig. 3) in the recording device 220.

In the example illustrated in Fig. 21A, the levels of the users are divided according to "whether or not the safety check operation can be performed" and "whether or not the excitation start operation can be performed". Further, in the example illustrated in Fig. 21A, it is assumed that the user who is not capable of performing the safety check operation is not capable of performing the excitation start operation. Therefore, as a result, the users are divided into three levels (upper/middle/lower levels). Specifically, the user belonging to level 1 (first level) has an authority to execute the safety check operation of the magnetic resonance imaging apparatus 100 and the excitation start operation of the magnet 110 included in the magnetic resonance imaging apparatus 100. The user belonging to level 2 (second level) lower than the level 1 has an authority to execute the safety check operation and does not have an authority to execute the excitation start operation. The user belonging to level 3 (third level) lower than the level 2 does not have the authority to execute the safety check operation and the authority to execute the excitation start operation.

In contrast, in the example illustrated in Fig. 21B, the levels are divided such that a user of a specific type of job (a user belonging to a "specific level"; in this example, a nurse) among the users of the "level 3" can check the remaining cooling time (an example of "information indicating the state of the magnet"). This is premised on the assumption that it is necessary to check the state of the magnetic resonance imaging apparatus 100 depending on the type of job. For example, it is considered that a user of a specific type of job receives an order for the content of the examination from a doctor and makes an operation schedule according to the start date of the use of the magnetic resonance imaging system 10. In addition, a configuration may be adopted in which the "user of a specific type of job" can check not only the remaining cooling time but also other states (any one of the demagnetized state, the cooling state, the cooling-completed state, the exciting state, or the excitation-completed state) of the magnet 110.

Further, in the example illustrated in Figs. 21A and 21B, the restrictions based on the type of job are not imposed on the cooling start operation. However, the restrictions may be imposed thereon similarly to other operations.

As described above, in the magnetic resonance imaging system 10 according to the present embodiment, the executable operations are restricted according to the type of job of the user, which makes it possible to improve safety. In addition, in the operation terminal 300, similarly, the executable operations can be restricted according to the type of job of the user.

### Safety Check and Excitation According to Type of Job of User

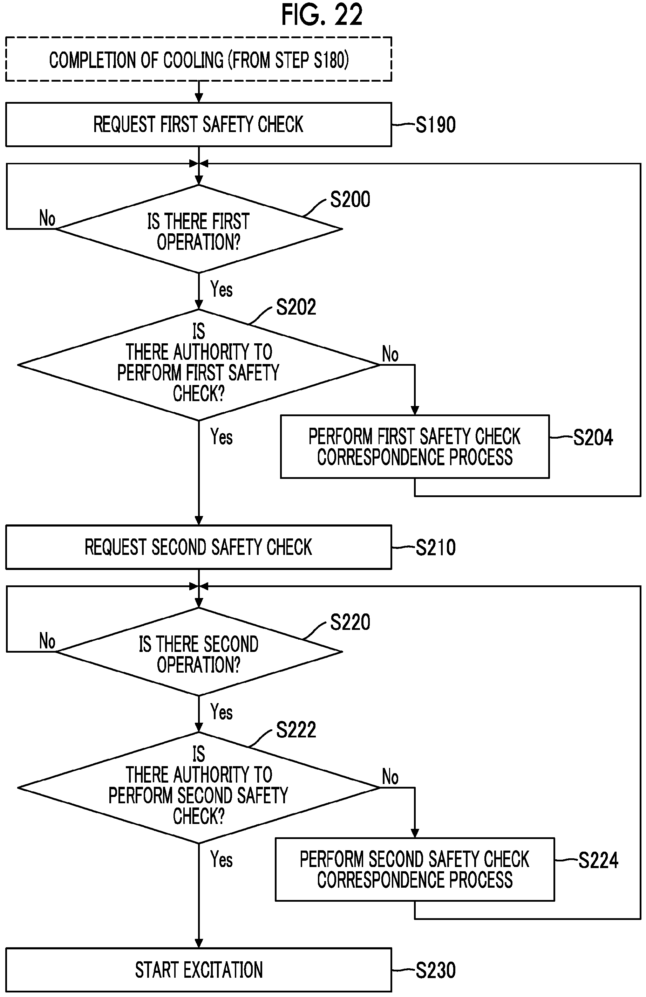

Fig. 22 is a flowchart in a case where the safety check and the excitation are performed according to the type of job of the user. The process until the safety check operation is performed in Step S200 is the same as that in Figs. 6 and 7, and the same processes are performed in the same step numbers as those in Figs. 6 and 7.

In the flowchart illustrated in Fig. 22, the processor 212 determines whether or not the user who has performed the first operation has the authority to perform the first safety check (check for the absence of the magnetic material and the absence of the person) (Step S202). The processor 212 can determine whether or not the user has the authority to perform the safety check operation (an aspect of a "specific operation") with reference to the tables illustrated in Fig. 8 and Figs. 21A and 21B. In a case where the user does not have the authority to perform the first safety check (NO in Step S202), the processor 212 does not receive the operation that the user has tried to execute and performs a first safety check correspondence process (Step S204). The "not receiving the operation" includes, for example, that the check box is not capable of being checked or that the OK button is not capable of being pressed (or tapped) in the state illustrated in Fig. 19. After the execution of the first safety check correspondence process in Step S204, the process returns to Step S200.

### First Safety Check Correspondence Process

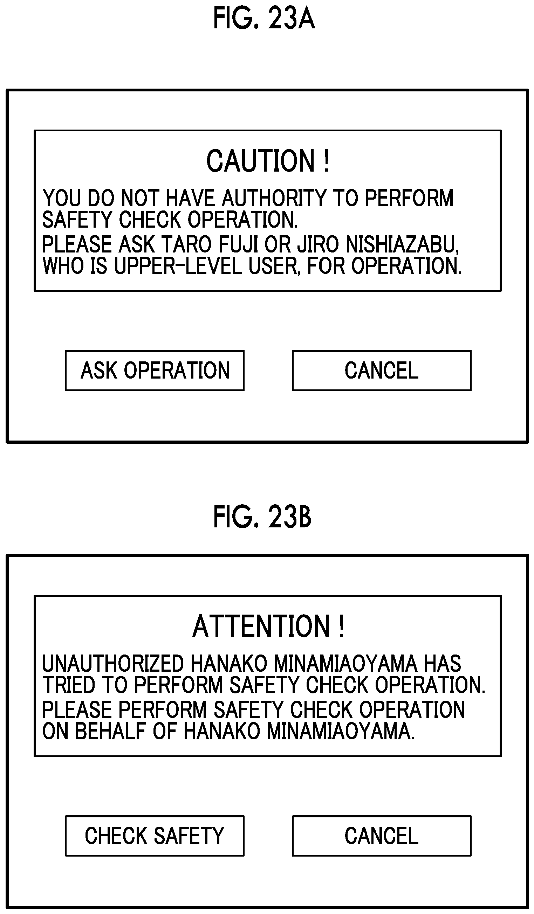

The processor 212 outputs at least one of information (safety check information 1) indicating that the user does not have the authority to execute the first safety check operation (specific operation) or information (safety check information 2) prompting an upper-level user to execute the first safety check operation (Step S204). Fig. 23A is a diagram illustrating an example of the output of the first safety check correspondence process (an example in which both of the information items are output). In Fig. 23A, a situation is assumed in which "Hanako Minamiaoyama" (nurse) who is a user of level 3 tries to execute the first safety check operation (specific operation). The processor 212 can display and output the information on a screen (display 202) of an operation terminal (the operation terminal 200; the first terminal apparatus) used by an unauthorized user. However, the processor 212 may output the information as voice through the speaker 206.

In a case where the user clicks or taps "ask operation" Fig. 23A, an information output request is transmitted from the processor 212 to the processor 312 (a processor of an operation terminal (here, the operation terminal 300; the second terminal apparatus) used by the upper-level user). In response to the information output request, the processor 312 outputs information (safety check information 2) illustrated in Fig. 23B (the output may be display output or voice output). Further, the processor 212 may output a message not to the operation terminal 300 but to a mobile terminal (a smartphone or a tablet terminal; an aspect of the second terminal apparatus) carried by the upper-level user (screen display or voice output).

In a case where the upper-level user clicks or taps "check safety" in the state illustrated in Fig. 23B, the screen illustrated in Fig. 19 is displayed on the operation terminal 300 or the mobile terminal such that the first safety check can be performed.

Further, in Figs. 23A and 23B, the case has been described where the unauthorized user uses the operation terminal 200 and the upper-level user uses the operation terminal 300. However, this relationship may be reversed. In addition, in Figs. 23A and 23B, the case has been described where the unauthorized user tries to execute the specific operation. However, the screen (see Fig. 19) for performing the safety check or the excitation may not be displayed according to the level of the user such that the unauthorized user is not capable of trying to execute the specific operation.

### Second Safety Check Correspondence Process

Similarly to the operation restrictions in the first safety check, the same process can be performed for the operation restrictions (Steps S222 and S224; a second safety check correspondence process) in the second safety check (excitation start check).

### Division of Roles of Operation Terminals

Further, in the magnetic resonance imaging system 10 according to the present embodiment, the safety check may be performed by only one of the operation terminal 200 and the operation terminal 300 or may be performed by both the operation terminal 200 and the operation terminal 300. In a case where the safety check is performed by both the operation terminals, one (for example, the operation terminal 200 which is the operation terminal for a local site) of the operation terminals 200 and 300 can be used as an operation terminal (first terminal apparatus) dedicated to the first operation, and the other (for example, the operation terminal 300 which is the operation terminal for a service site) can be used as an operation terminal (second terminal apparatus) capable of performing the first operation and the second operation. For example, it is considered that a user (engineer) of level 2 performs the first safety check with the operation terminal 200 and a user (chief engineer) of level 1 performs (the monitoring of the first safety check and) the second safety check with the operation terminal 300. In this case, the operation terminal 200 is the first terminal apparatus, and the operation terminal 300 is the second terminal apparatus. In a case where this division of roles is performed, the screen for the second operation (excitation start check and operation) may not be displayed on the operation terminal 200.

In addition, which of the operation terminals 200 and 300 is the first terminal apparatus or the second terminal apparatus may not be fixed, and the roles may be interchanged according to the level (type of job) of the user. For example, it is considered to set the roles of the operation terminals 200 and 300 according to the ID or type of job of the logged-in user.

### Effects of Embodiment

As described above, according to the first embodiment, not only specialized service personnel with advanced knowledge and skills but also general users can correctly understand the state of the magnet. In addition, since an action, such as safety check, is required, the user can easily understand what to do and can reliably perform an appropriate operation.

### Others

Further, the present invention is not limited to the above-described embodiment and can be modified in various ways.

### Explanation of References

10: magnetic resonance imaging system
100: magnetic resonance imaging apparatus
101: refrigerator
102: compressor
103: control unit
104: pressure measurement unit
106: shield temperature measurement unit
107: magnet temperature measurement unit
108: ammeter
109: voltmeter
110: magnet
120: bed apparatus
200: operation terminal
202: display
212: processor
212A: calculation unit
212B: remote transmitting and receiving unit
300: operation terminal
302: display
312: processor
312A: remote transmitting and receiving unit
312B: analysis unit
S100 to S250: each step of operation method

## Claims

1. An operation terminal for a magnetic resonance imaging apparatus, the operation terminal comprising:
a processor configured to:
acquire information indicating a temperature of a magnet provided in the magnetic resonance imaging apparatus from the magnetic resonance imaging apparatus;
calculate a remaining cooling time, which is a time required until the magnet is cooled to a cooling-completed state, on the basis of the acquired information; and
output information indicating the remaining cooling time.

2. The operation terminal according to claim 1, further comprising:
a non-transitory tangible recording medium in which data of a cooling curve, which indicates a relationship between a time from a start of the cooling of the magnet and the temperature of the magnet and which has been generated on the basis of an actually measured value, is recorded,
wherein the processor is configured to calculate the time with reference to the recorded data of the cooling curve.

3. The operation terminal according to claim 2,
wherein, as the data of the cooling curve, data of a plurality of cooling curves corresponding to a type of a cooling device that cools the magnet and a change in the cooling device over time is recorded in the recording medium, and
the processor is configured to interpolate the data of the plurality of cooling curves according to the type of the cooling device and the change in the cooling device over time to calculate the remaining cooling time.

4. The operation terminal according to claim 2 or 3,
wherein the processor is configured to newly generate data of a cooling curve indicating a relationship between a cooling time of the magnet and the temperature of the magnet on the basis of an actually measured value of the temperature of the magnet and to record the generated data of the cooling curve in the recording medium.

5. The operation terminal according to any one of claims 2 to 4,
wherein the processor is configured to display the data of the cooling curve on a display device.

6. The operation terminal according to any one of claims 1 to 5,
wherein the cooling-completed state is a state in which a superconducting state of the magnet is maintained and it is possible to start exciting the magnet.

7. The operation terminal according to any one of claims 1 to 6,
wherein the processor is configured to output the information using at least one of display output or voice output.

8. The operation terminal according to any one of claims 1 to 7,
wherein the processor is configured to discretely output the information according to the remaining cooling time.

9. The operation terminal according to any one of claims 1 to 8,
wherein the processor is configured to determine a small granularity for the information stepwise according to the remaining cooling time and to output the information with the determined granularity.

10. A method for operating an operation terminal for a magnetic resonance imaging apparatus, the operation terminal including a processor, the method comprising:
causing the processor to:
acquire information indicating a temperature of a magnet provided in the magnetic resonance imaging apparatus from the magnetic resonance imaging apparatus;
calculate a remaining cooling time, which is a time required until the magnet is cooled to a cooling-completed state, on the basis of the acquired information; and
output information indicating the remaining cooling time.

11. A magnetic resonance imaging system comprising:
the operation terminal according to any one of claims 1 to 9; and
the magnetic resonance imaging apparatus.

12. The magnetic resonance imaging system according to claim 11, further comprising:
a cooling device that cools the magnet; and
a thermometer that measures the temperature of the magnet,
wherein the magnet is a superconducting magnet for generating a static magnetic field.
